# EUROPEAN PATENT APPLICATION

(11) **EP 0 979 729 A1**
(43) Date of publication of application: **16.02.2000**
(21) Application number: 98115015.4
(22) Date of filing: 10.08.1998
(51) Int. Cl.: B32B 31/00

(54) **Film applying method**

(71) Applicant: SOMAR CORPORATION, Tokyo 104-0061 (JP)
(72) Inventor: Washizaki, Yoji, Tokyo 104-0061 (JP); Kitagawa, Kenji, Tokyo 104-0061 (JP); Ozawa, Osamu, Tokyo 104-0061 (JP)
(74) Representative: Grünecker, Kinkeldey, Stockmair & Schwanhäusser Anwaltssozietät

(57) **Abstract**

A laminated film 14 fed from a film roll 12 in a film applying apparatus 10 has its cover film 14C cut together with a photosensitive resin layer 14B in the direction of film width by a half cutter 38. At this time the edges of disk cutters 38A and 38B of the half cutter 38 bite into part of the thickness of a light-transmissible base film 14A for supporting the photosensitive resin layer 14B and surely cut the photosensitive resin layer 14B.

## Description

### BACKGROUND OF THE INVENTION

### FIELD OF THE INVENTION

The present invention relates to a film applying method for applying a film on the surface of a substrate exemplified by a printed circuit board or a glass substrate for a liquid crystal display apparatus and a plasma display apparatus.

### RELATED ART

In a process of manufacturing a printed circuit board used in such an electronic equipment as a computer and the like, a laminated film, which is formed by forming a photosensitive resin layer directly on or through an interposed layer on a light-transmissible base film (ordinarily a transparent resin film represented by a polyester film) and covering this film with a cover film, has the cover film peeled off from it and then is applied on a conductive layer of the surface of a printed wiring board. And after this, a wiring pattern film is put on this film and the photosensitive resin layer is exposed to light for a specified time through this wiring pattern film and said light-transmissible base film. Next, after the light-transmissible base film is peeled off, the exposed photosensitive resin layer is developed to form an etching mask pattern, and then unnecessary portions of said conductive layer is etched off, and thus a printed circuit board having a desired wiring pattern is formed. And in a process of forming display cells on a glass substrate of a liquid crystal display apparatus and a plasma display apparatus, a similar laminated film is applied on the glass substrate.

As a film applying apparatus for applying such a laminated film as described above, there is what is called a film applying apparatus of a continuously applying type which reels out a continuous film from a film roll, arranges this film so that its photosensitive resin layer is parallel with and opposite to the film-applying surface side of a plurality of substrates being conveyed intermittently in sequence on a substrate conveying surface by a conveying means, passes both of the film and the substrates through between laminating rolls in a state where they are superposed on each others and conveys the plurality of substrates as continuously pressure-applying the film on the substrates.

The light-transmissible base film applied on a substrate must be peeled off from the substrate as leaving the photosensitive resin layer on the substrate side before or after exposure and prior to a developing process, and the film must be separated among the respective substrates simultaneously with or before or after peeling.

In case of pulling the light-transmissible base film in the direction of peeling, there is a problem that when a photosensitive resin layer on its reverse surface is continuous from a portion projecting from a substrate to the substrate, even the portion of a photosensitive resin layer which must be left on the surface of the substrate at the time of peeling off the light-transmissible base film results in being peeled off following the projecting portion of the photosensitive resin layer.

In order to solve these problems, for example, a film peeling apparatus up to now disclosed in a Japanese laid-open publication Tokkaihei No.5-338040 peels off a cover film from a laminated film at the upstream side of a laminating roll unit and then cuts by means of a cutter a portion of an exposed photosensitive resin layer corresponding to each space between the respective substrates at two positions having a slightly wider space between them than a space between the substrates, and then peels off by means of an adhesive tape a portion of the photosensitive resin layer corresponding to each space between the respective substrates, and passes the film together with the substrates in this state through between the laminating rolls to pressure-apply them on each other.

Therefore, in the film applying apparatus of the Japanese laid-open publication Tokkaihei No.5-338040, since each portion of a film between the respective substrates, said film being continuously applied on the substrates being conveyed in sequence, has no photosensitive resin layer, the photosensitive resin layer is not peeled off from the substrates in case of continuously peeling off a light-transmissible base film from the substrates after applying the film on the substrates.

And for example, in a film peeling apparatus disclosed in a Japanese laid-open publication Tokkaihei No.7-157186, after a film is continuously applied on substrates, only a photosensitive resin layer is cut in the direction of film width along an end edge of each substrate at a position between the respective substrates and then a light-transmissible base film is continuously peeled off, and at this time the peeled-off light-transmissible base film side has the photosensitive resin layer applied on it at each space between the respective substrates.

And in a film applying apparatus disclosed in a Japanese laid-open publication Tokkaihei No.8-150694, a slit is formed in advance in the direction of film width in a portion of a photosensitive resin layer corresponding to each space between the respective substrates and the film is applied continuously on the substrates as it is and then the film is cut at a position between the respective substrates and the light-transmissible base film is peeled off from each cut end edge.

Moreover, in a film applying apparatus disclosed in a Japanese laid-open publication Tokkaihei No.7-110575, prior to peeling off a cover film both of the cover film and a photosensitive resin layer on its inside are cut in the direction of film width at two positions having space therebetween slightly wider than each space between the respective substrates, and then only a cover film of a portion to be applied on a substrate is peeled off by an adhesive tape to expose the photosensitive resin layer, and in this state the film is continuously applied on the substrates. After being applied, the light-transmissible base film is cut by a cutter at a position between the respective substrates.

In any case as described above, a cutting line needs to be formed between an unnecessary portion and a necessary portion of a photosensitive resin layer so that a portion of the photosensitive resin layer applied on a board is not peeled off following an unnecessary portion of the photosensitive resin layer when attempting to strip off a light-transmissible base film together with the unnecessary portion of the photosensitive resin layer.

A disk-shaped disk cutter or a straight-edged cutter is used as a means for forming such a cutting line.

In order to cut a photosensitive resin layer or the photosensitive resin layer together with a cover film provided at the outside of this photosensitive resin layer when cutting the photosensitive resin layer, namely, when performing what is called "a half-cutting operation" by means of such a cutter, it is necessary to perform a positioning control of the edge of the cutter in the direction of film thickness in a very high accuracy.

However, it is very difficult to perform a precise positioning control of the edge of a cutter in the direction of film thickness, and it is particularly difficult in a manufacturing accuracy to make a disk-shaped cutter into the shape of a right circle, and an error of ± several microns or so occurs in diameter. On the other hand, a cover film and a photosensitive resin layer also have some errors in thickness and therefore it has been difficult to perfectly cut the photosensitive resin layer.

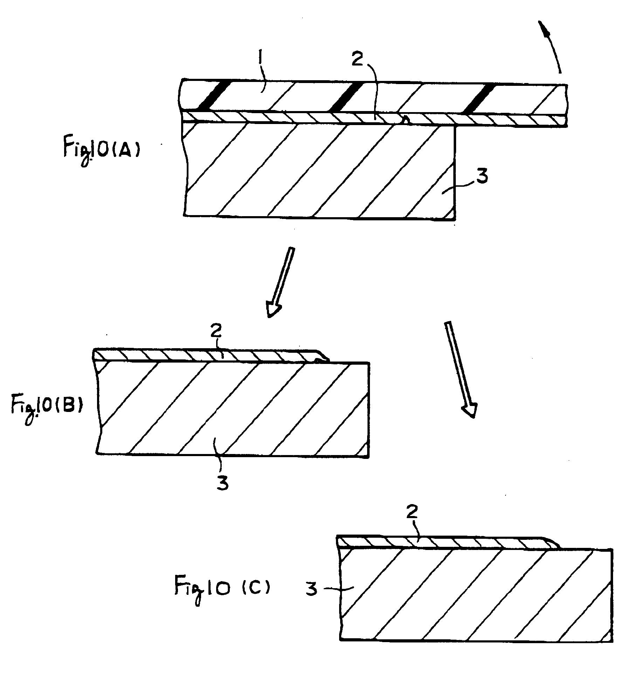

As seen from a cutting line 4 shown in Figure 10(A) for example, when a photosensitive resin layer 2 is imperfectly cut, a dividing line of the photosensitive resin layer 2 is disarranged as shown in Figures 10(B) and 10(C) at the time of peeling off a light-transmissible base film 1, and therefore a problem occurs that an essentially necessary portion of the photosensitive resin layer 2 is peeled off, or an originally unnecessary portion of the photosensitive resin layer 2 is left on a board 3 and is adhered on the surroundings in a succeeding process.

### SUMMARY OF THE INVENTION

The present invention has been developed in consideration of the above-mentioned existing problems, and has an object of providing a film applying method which make it possible to surely cut a photosensitive resin layer without performing a precise positioning control and a dimension control of the edge of a cutter in the direction of film thickness.

The present invention attains the above-mentioned object by means of a film applying method which exposes a laminated film formed by laminating at least a light-transmissible base film and a photosensitive resin layer on each other at least in a range where said photosensitive resin layer can be applied on a substrate, and then feeds the laminated film along a substrate conveying surface in a state where the photosensitive resin layer faces the film applying surface of the substrates being conveyed on the substrate conveying surface, and sends the laminated film and the substrates into a laminating roll unit, and applies the laminated film on the substrates, and cuts said photosensitive resin layer by a cutter in the direction of film width before or after said applying operation at a position near an end portion in the conveying direction of the substrates; said film applying method making the edge of said cutter bite into said light-transmissible base film when cutting said photosensitive resin layer, and cutting it as leaving part of the thickness of said light-transmissible base film as it is not cut.

It may be possible that the depth to which the edge of said cutter bites into said light-transmissible base film is 1/2 or less of the thickness of said light-transmissible base film.

And it may be possible that the depth to which the edge of said cutter bites into said light-transmissible base film is 20µm or less.

Further it may be possible that the depth to which the edge of said cutter bites into said light-transmissible base film is about 10µm.

It may be possible that said laminated film is formed by laminating a cover film on the outside of said photosensitive resin layer, said photosensitive resin layer is cut at the upstream of said laminating roll unit, and at the same time as said cutting operation said cover film is cut by said cutter in a state where it is laminated on the photosensitive resin layer, and after the cutting, said cover film is peeled off from the photosensitive resin layer at least in a range where it is applied on the substrate.

And it may be possible that a light-transmissible base film which is applied on said substrate and has a photosensitive resin layer cut on it is continuously peeled off from the substrates in a state where a portion of the photosensitive resin layer corresponding to each space between the respective substrates and being between the cutting lines made by said cutter is left as it is applied on the light-transmissible base film.

Further, it may be possible that a pair of cutters are disposed leaving a space corresponding to the space between said substrates in the film feeding direction and these cutters cut the photosensitive resin layer and part of the thickness of the light-transmissible base film as moving in the direction of film width at the same time.

Furthermore, it may be possible that said pair of cutters, respectively, are disk cutters capable of turning in the direction of film width.

In the present invention, since at the time of cutting a photosensitive resin layer the edge of its half cutter bites into part of the thickness of a light-transmissible base film for supporting the photosensitive resin layer, the photosensitive resin layer is surely cut even if the cutter varies in dimension and the photosensitive resin layer varies in thickness.

### BRIEF DESCRIPTION OF THE DRAWINGS

Figure 1 is a schematic side view showing a film applying apparatus used in the working of the present invention and including partially a block diagram.
Figure 2 is a magnified sectional view showing a laminated film used in the same film applying apparatus.
Figure 3 is a perspective view showing the main part of a half cutter in the same film applying apparatus.
Figure 4 is a block diagram showing a control system of the same film applying apparatus.
Figure 5 is a magnified sectional view showing a laminated film being cut by the half cutter.
Figure 6 is a magnified sectional view showing a state where a laminated film is applied on a substrate.
Figure 7 is a magnified sectional view showing a state where a laminated film is peeled off from a substrate.
Figure 8 is a magnified sectional view showing another lamination film.
Figures 9(A) - 9(E) are magnified sectional views showing various states where a laminated film is applied on a substrate.
Figures 10(A) - 10(E) are magnified sectional views showing a laminated film which is imperfectly half-cut.

### DETAILED DESCRIPTION OF THE PREFERRED EMBODIMENTS

Embodiments of the present invention are described in detail with reference to the drawings in the following.

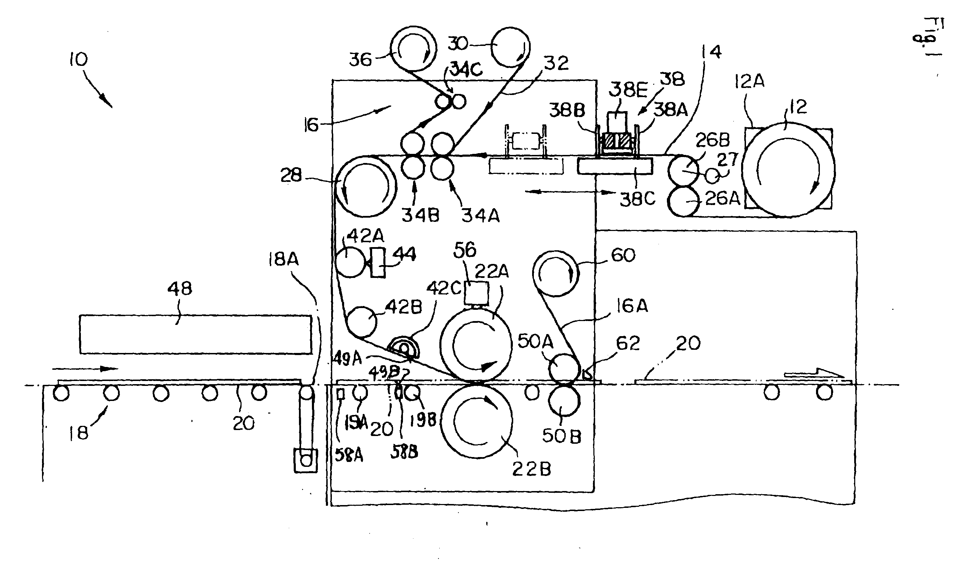

A film applying apparatus 10 used in the working of the present invention, as shown in Figure 1, reels out a laminated film 14 from a film roll 12 which is a film feeding source, peels off a cover film 14C (as described later) forming said laminated film 14 by means of a cover film peeling unit 16, and then applies the laminated film 14 on the upper surfaces of a plurality of substrates 20 being conveyed intermittently in sequence by a substrate conveying unit 18, passes the laminated film together with said substrates 20 through between a pair of upper and lower laminating rolls 22A and 22B, and pressure-applies the laminated film 14 on the substrates 20.

The laminated film 14 continuously pressure-applied on the plural substrates 20 is continuously peeled off from the respective substrates 20 and thereby is divided into the respective substrates separately from each other.

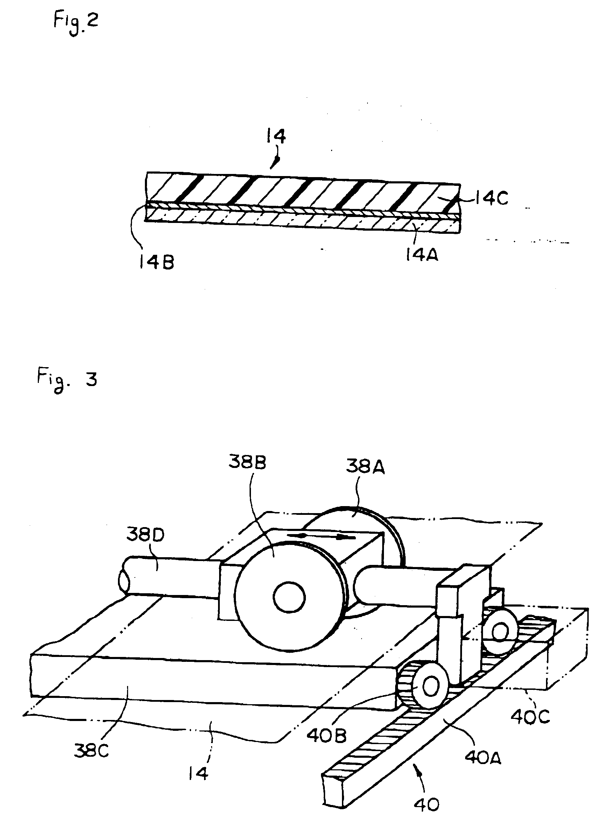

Said laminated film 14 is as shown in Figure 2 composed of a light-transmissible base film 14A, a photosensitive resin layer (including or not including interposed layer) 14B laminated on this light-transmissible base film 14A, and a cover film 14C laminated so as to cover the photosensitive resin layer 14B, and can be reeled out continuously from the film roll 12 which is rolled in the shape of a belt.

Here, "light-transmissible" in the light-transmissible base film 14A means the capability of transmitting a light or beam to which the photosensitive resin layer 14B is exposed, namely, the capability of transmitting visible rays, ultraviolet rays, X-rays, electron rays, and the like.

The film roll 12 is made so that its reeling-out tension is controlled by a torque motor 12A. The laminated film 14 reeled out from said film roll 12 is wound around a pair of guide rolls 26A and 26B, is extended from here along a horizontal film conveying surface, and is wound around a tensioning suction roll 28.

This tensioning suction roll 28 has a number of suction holes on its outer cylindrical surface and is turned as sucking the laminated film 14 wound around it (not illustrated in detail).

Here, the laminated film 14 is arranged so that the cover film 14C is positioned at the upper side of it between said guide roll 26B and said tensioning suction roll 28.

Said cover film peeling unit 16 is provided just before said tensioning suction roll 28, puts an adhesive tape 32 reeled out from an adhesive tape roll 30 as making its adhesive layer face the cover film 14C side and the laminated film 14 together between two pairs of pressing rolls 34A and 34B, and reels in the cover film 14C as peeling off it from the photosensitive resin layer 14B at the same time as reeling in the adhesive tape 32 by means of a reeling roll 36 through the guide roll 34C.

A rotary encoder 27 is attached to said guide roll 26B and outputs a pulse signal having a corresponding number of pulses to the feed of the laminated film 14.

A half cutter 38 is provided between said guide roll 26B and said cover film peeling unit 16, which half cutter 38 cuts the cover film 14C together with the photosensitive resin film 14B in the direction of film width as leaving the light-transmissible base film 14A on the laminated film 14 at two positions having a specific space between them in the film feeding direction.

This half cutter 38 comprises a pair of disk cutters 38A and 38B disposed with said specific space between them in the film feeding direction, a horizontal cutter stand 38C which is disposed opposite to the edges (lower ends) of the disk cutters 38A and 38B with a film conveying surface between the cutter stand 38C and the edges and supports said laminated film when said disk cutters 38A and 38B are moved in the direction of film width, and a film pressing cylinder 38E for pressing down the laminated film 14 onto the cutter stand 38C when the disk cutters 38A and 38B are moved. Hereupon, the cutter stand 38C is formed so as to be long enough to cover the lower side in the direction of width of the laminated film 14 in Figure 1.

As shown in Figure 3, said disk cutters 38A and 38B are driven in the direction of film width by a drive unit 38D composed of a rodless cylinder for example, and are made so as to make it possible to cut the cover film 14C one time when going or returning, or two times when going and returning for one going and returning motion in the direction of width.

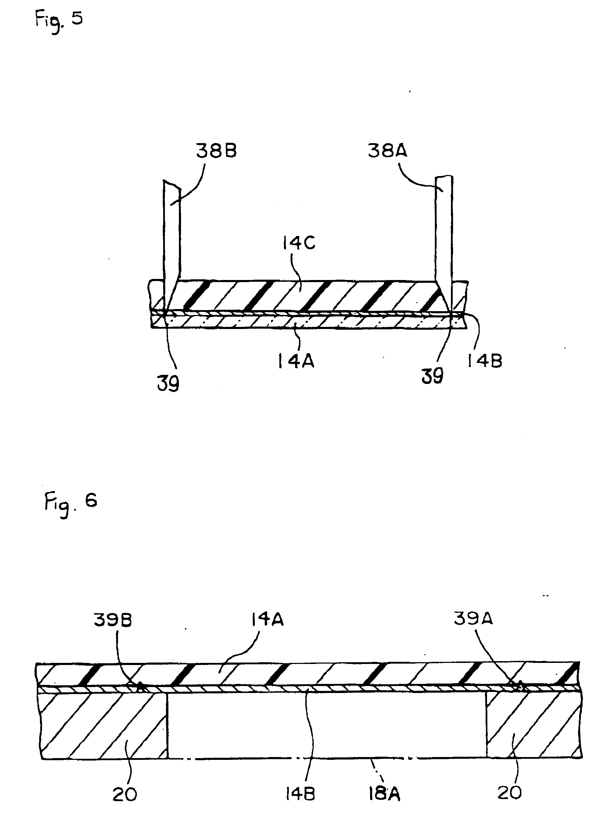

Hereupon, said disk cutters 38A and 38B are set so that their edges 39 bite into a part of the thickness of the light-transmissible base film 14A as shown in Figure 5 when cutting the cover film 14C and the photosensitive resin layer 14B.

Ordinarily, in case that the photosensitive resin layer 14B is several µm in thickness for example, the cover film is 10 - 50 µm and the light-transmissible base film is about 100µm, and on the other hand since the disk cutters 38A and 38B vary by several microns at most in diameter in the radial direction, the photosensitive resin layer 14B can be surely cut by setting the edges 39 so as to bite into the light-transmissible base film 14A by 10µm or so.

Since even if the light-transmissible base film 14A is cut to a half thickness of it said light-transmissible base film 14A is not broken in a succeeding process, even if the disk cutters 38A and 38B become the greatest in diameter within a specified range of variation, their bite depth does not exceed 20µm and therefore the light-transmissible base film 14A is not cut to a half thickness of it in almost cases and not broken in a succeeding process.

Said cutter stand 38C and said drive unit 38D can be moved synchronously with and in the same direction as and at an equal speed to feeding of the laminated film 14 by a half cutter moving unit 40. Accordingly, the disk cutters 38A and 38B can cut the laminated film without stopping the feed of it, namely, can perform what is called "flying cut".

This half cutter moving unit 40 comprises a rack 40A disposed in parallel with the film conveying surface and pinions 40B engaging with the rack 40A, and moves the disk cutters 38A and 38B and the cutter stand 38C synchronously with the laminated film 14 by mounting the pinions 40B on the cutter stand 38C side and the drive unit 38D side and driving said pinions 40B by means of a motor 40C.

The half cutter 38 and the half cutter moving unit 40 are controlled by a controller 46, which outputs timing signals at the time when the half cutter 38 has started cutting the film in sequence to the first to third counters 47A, 47B and 47C.

These first to third counters 47A, 47B and 47C start, respectively, counting pulse signals from said rotary encoder 27 when the cutting start timing signals from the controller 46 are inputted, and when a film feed until a cut position on the laminated film 14 reaches a specific point (virtual point) 49A provided in the vicinity of the entry side of said laminating rolls 22A and 22B has been counted, these counters output arrival detection signals to said controller 46. After the first to third counters 47A, 47B and 47C have outputted the arrival detection signals, they are reset by the controller 46.

Guide rolls 42A and 42B for guiding the laminated film 14 from which the cover film has been peeled off (the light-transmissible base film 14A and the photosensitive resin layer 14B) and a film preheater 42C are arranged in this order between said tensioning suction roll 28 and the laminating rolls 22A and 22B.

A tension pickup 44 is provided on said guide roll 42A at the upside and detects a tension of the laminated film 14 at this position with a force applied to the guide roll 42A, and thereby a negative pressure of said tensioning suction roll 28 is controlled through the controller 46 so that the film tension is optimum.

The guide roll 42B guides the laminated film 14 so that it can enter aslant between the laminating rolls 22A and 22B, and the preheater 42C heats the laminated film 14 to a specific temperature just before pressure-adhering it to a substrate.

A reference character 48 of Figure 1 denotes a heater for heating a substrate 20 on the substrate conveying surface 18A formed on the upper end of the substrate conveying unit 18. At the downstream side of said laminating rolls 22A and 22B, pinch rolls 50A and 50B disposed distantly from them in the substrate conveying direction are disposed, and above them a supporting film reeling roll 60 is disposed. The upper pinch roll 50A is opened and closed by the controller 46.

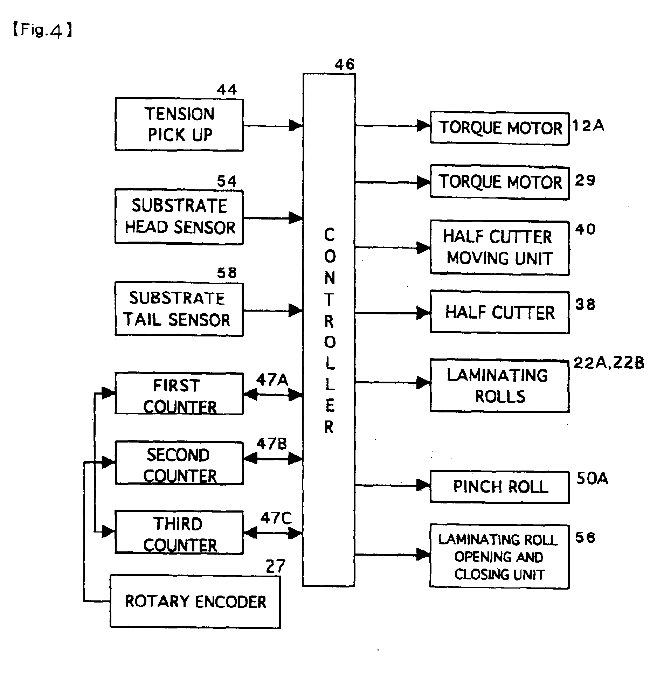

Said laminating roll 22A at the upper side can be freely separated from and contacted with (opened and closed in relation to) the laminating roll 22B at the lower side by a laminating roll opening and closing unit 56 (see Figures 1 and 4), and is "closed" by the controller 46 so as to put a substrate 20 between the laminating rolls 22A and 22B when the head of the substrate reaches a position between them, and is "opened" when the tail of the substrate goes out from between the laminating rolls 22A and 22B.

As shown in Figure 1, a first substrate sensor 58A, a free roller 19A, a second substrate sensor 58B and a feed roller 19B are arranged along said substrate conveying surface 18A in this order from the heater 48 side between the exit side of said heater 48 and the laminating rolls 22A and 22B. The feed roller 19B can be turned at the same speed as the laminating rolls 22A and 22B.

Said second substrate sensor 58B is disposed just below a waiting point (virtual point) 49B which is at a distance from the laminating rolls 22A and 22B, said distance being equal to the distance between said specific point 49A and the laminating rolls 22A and 22B.

The controller 46 controls a conveying unit 18, a laminating roll opening and closing unit 56, and the like according to signals from said first and second substrate sensors 58A and 58B and according to signals from said first to third counters 47A to 47C, and these are in detail described later.

Next, operation of said film applying apparatus is described.

The film applying apparatus first reels out the laminated film 14 from the film roll 12, passes it between the laminating rolls 22A and 22B in a waiting state (open state) through the guide rolls 26A and 26B, the tensioning suction roll 28, and the guide rolls 42A and 42B, and further passes it between the pinch rolls 50A and 50B in an open state, and further makes the head of the limitation film 14 be reeled in by the supporting film reeling roll 60, and then closes the pinch roll 50A.

At this time the cover film 14C is peeled off by the cover film peeling unit 16 from its head and is reeled in.

And the controller is set by inputting such data as the space between the tail of a preceding substrate and the head of a succeeding substrate, a film applying length onto a substrate (patterning length), and a margin from a applying border to an end of a substrate, and the like.

Next, the whole film applying apparatus 10 is operated, and at this time the half cutter 38 is set in advance so that the distance in the film feeding direction between the disk cutters 38A and 38B is slightly greater than the distance between the tail of a proceeding board and the head of a succeeding substrate in a state where the laminated film 14 is applied on these substrates.

When the film applying apparatus 10 is operated, the controller 46 first starts turning the pinch rolls 50A and 50B, and applying a negative pressure to and turning the tensioning suction roll 28. The rotary encoder starts generating pulses. And when a feeding speed of the laminated film 14 becomes constant, as conveying the laminated film 14 the film applying apparatus 10 drives the disk cutters 38A and 38B by the drive unit 38D as moving the half cutter 38 synchronously with the laminated film 14 by the half cutter moving unit 40, and cuts the cover film 14C together with the photosensitive resin layer 14B at the back side of it in the direction of film width (see Figure 5). As described above, since at the time of this cutting the edges of the disk cutters 38A and 38B are set so as to bite to a depth of 10µm or so into the light-transmissible base film 14A, the disk cutters 38A and 38B can cut the photosensitive resin layer 14B without fail even if the radiuses of their edges come to the minimum limit of variation due to variation of the disk cutters 38A and 38B in a manufacturing process.

And even if the diameters of the disk cutters 38A and 38B become the maximum within an acceptable range of variation, it does not happen that the light-transmissible base film 14A is excessively cut in depth and is broken from this area in a succeeding process.

On the other hand, since the cover film peeling unit 16 strongly pressure-applies the adhesive tape 32 reeled out from the tape roll 30 on the cover film 14C between the pressing rolls 34A and 34B and then reels in the cover film 14C by the reeling roll 36, the cover film 14C is reeled in together with the adhesive tape 32 and is peeled off from the photosensitive resin layer 14B.

Since the adhesive tape 32 is continuously pressure-applied on the cover film 14C, the portions in which cutting lines are marked by the disk cutters 38A and 38B are also adhered surely to the adhesive tape and are reeled in by the reeling roll 36.

When the cover film 14C is cut by the disk cutters 38A and 38B of the half cutter 38, the optimum tension for cutting is applied to the laminated film 14 by the torque motor 12A for controlling rotation of the film roll 12 and said tensioning suction roll 28 for feeding the laminated film 14 as sucking it. After cutting, the half cutter 38 is reset at a waiting state.

When a timing signal showing that the half cutter 38 has started cutting the film is inputted, the first counter 47A starts counting the number of pulses generated by the rotary encoder 27.

The laminated film 14 in which the cover film 14C is peeled off by the cover film peeling unit 16 and the photosensitive resin layer 14B is exposed passes the guide rolls 42A and 42B and the position of the film preheater 42C as making said photosensitive resin layer 14B face the substrate conveying surface 18A side, and reaches the vicinity of the laminating rolls 22A and 22B.

On the other hand, a substrate 20 is kept waiting at the position of the heater 48 and when the count value of said first counter 47A reaches a timing value (K1) of accepting a substrate, the substrate conveying unit 18 is turned on by the controller 46 and an instruction of accepting the second substrate 20 is issued.

When the head of the first substrate 20 passes the first substrate sensor 58A and reaches the second substrate sensor 58B, the substrate conveying unit 18 is stopped and the substrate 20 comes to be kept waiting at the waiting point 49B.

When the count value of the first counter 47A reaches a numerical value (K2) at which a cutting line in the film reaches the specific point 49A, the controller 46 drives the substrate conveying unit 18 (including a feed roller 19B) at that timing and feeds the substrate 20 synchronously with the film into between the laminating rolls 22A and 22B.

The upper laminating roll 22A is brought from a "open" state into a "close" state by the laminating roll opening and closing unit 56 when the head of the substrate 20 comes just below the roll 22A, and the substrate 20 is put together with the laminated film 14 between the laminating rolls 22A and 22B, and thereby the laminated film 14 is applied on the substrate 20 in a state where the photosensitive resin layer 14B is pressure-applied on the upper surface of the substrate 20 being conveyed by the substrate conveying unit 18.

In this case, said value K2 is set so that the position where cutting is performed by said disk cutter 38B at the downstream side is positioned on the film-applied surface near the tail of a preceding substrate, and the position where cutting is performed by said disk cutter 38A at the upstream side is positioned on the film-applied surface near the head of a succeeding substrate.

On the other hand, as for the succeeding substrate (second substrate), when the count value of the first counter 47A reaches the number of pulses corresponding to the length of the substrate, a cutting operation of the half cutter 38 is started by the controller 46, and at the same time a pulse counting operation by the second counter 47B is started.

After this, when the count value of the second counter 47B reaches the substrate length, the third counter 47C starts counting, and then the first counter 47A starts counting, and such a process is repeated.

The second or later substrate is stopped temporarily in a state where the head of the substrate has reached the first substrate sensor 58A, and then after the tail of the substrate 20 is detected by the second substrate sensor 58B, a succeeding substrate 20 proceeds until its head is detected by the second substrate sensor 58B, and is kept waiting at the waiting point 49B and is controlled in the same way as said first substrate 20.

As described above, when the substrate conveying unit 18 conveys a substrate 20 to the laminating rolls 22A and 22B, in case that it makes the substrate 20 reach the vicinity of the entry of the laminating rolls 22A and 22B earlier than the laminated film 14 and stops it temporarily and then makes it proceed again synchronously with the time when a corresponding position on the laminated film 14 has approached there, the substrate 20 and the laminated film 14 are more surely synchronous with each other.

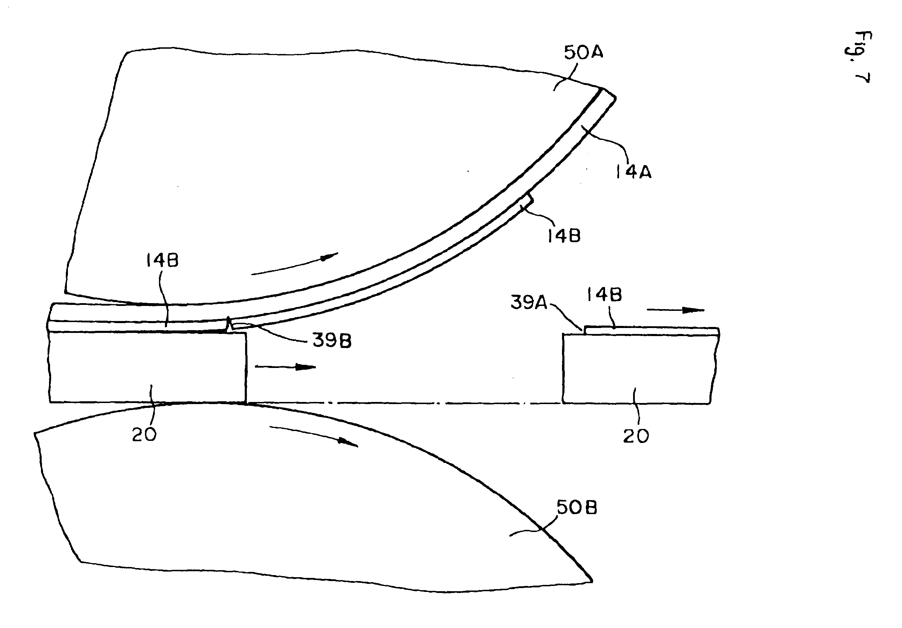

Therefore, cutting lines 39A and 39B obtained by cutting the laminated film applied on plural substrates 20 being intermittently conveyed by means of the disk cutters 38A and 38B are formed as shown in Figure 6.

In this state, when the light-transmissible base film 14A applied on a substrate is peeled off and reeled in by the base film reeling roll 60 through the upper pinch roll 50A, as shown in Figure 7 the photosensitive resin layer 14B on the substrate 20 is left as it is applied on said substrate 20 and the photosensitive resin layer 14B between the respective substrates 20 and 20, as it has no object to apply, is separated at the positions of the cutting lines 39A and 39B from the photosensitive resin layer 14B on the substrates 20 and is reeled in by the base film reeling roll 60 in a state where it is applied on the light-transmissible base film 14A.

Therefore, at the same time when the light-transmissible base film 14A is peeled off from the substrates 20, the respective substrates 20 result in being separated from each other. When the outer surface of the upper pinch roll 50A is cooled, the viscosity of the photosensitive resin layer 14B is lowered and thereby the separation is more surely performed.

Hereupon, it is preferable that a separating member for guiding the light-transmissible base film 14A at an acute angle, as shown by character 62 in Figure 1, at the vicinity of the exit side of the pinch rolls 50A and 50B. In this case the light-transmissible base film side of the photosensitive resin layer 14B and the substrate 20 side are smoothly separated.

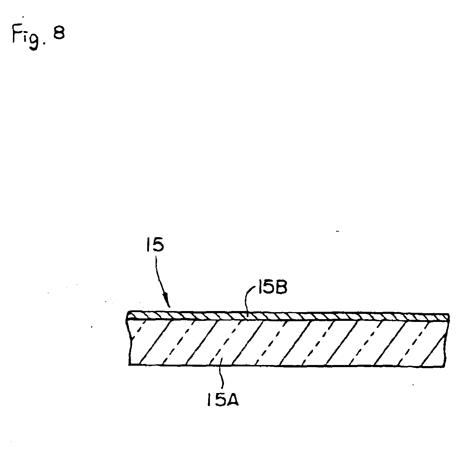

Although in the above-mentioned embodiment the laminated film is formed by laminating a light-transmissible base film, a photosensitive resin layer and a cover film on one another, the present invention can be also applied to a case of using a laminated film 15 which is composed of a light-transmissible base film 15A and a photosensitive resin layer 15B and is not provided with a cover film, as shown in Figure 8. In this case a cutter cuts the photosensitive resin layer only, or the photosensitive resin layer and part of the transparent supporting film.

Hereupon, cutting in the present invention may be to shut off the photosensitive resin layer and include substantially to remove it.

And although said half cutter 38 flying-cuts a laminated film 14 as moving synchronously with the laminated film 14, the present invention is not limited to this and may include a composition which, for example, is provided with an accumulator for accumulating a laminated film 14 between the half cutter 38 and the laminating rolls 22A and 22B, and stops feeding of the laminated film 14 at the position of the half cutter 38 and cuts a cover film 14C, while feeding the laminated film 14 to the laminating rolls 22A and 22B.

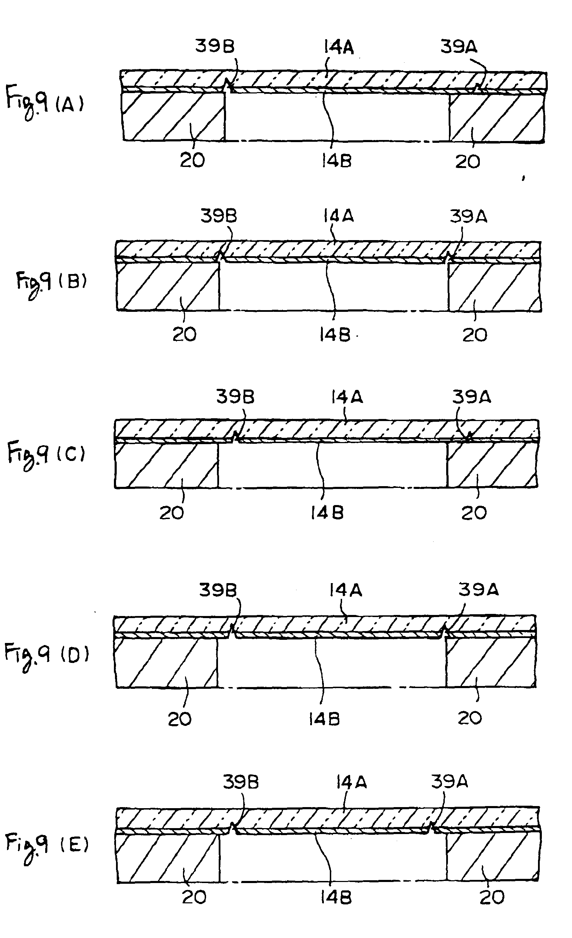

And although said cutting lines 39A and 39B are offset slightly nearer to the center side than the end in the conveying direction of a substrate 20 in a state where the film is applied on the substrate 20, the present invention is not limited to this and they may be at the same position as the end of the substrate 20 or at a position slipped out of it, as shown in Figures 9(A) to 9(E).

And in case of applying a laminated film on the lower side or both sides of a substrate, the present invention is also applied to a case of applying the laminated film on one surface or both surfaces of the substrate as conveying the substrate in the vertical direction or in an inclined direction.

Moreover, in the above-mentioned embodiment, although the light-transmissible base film 14A is applied on substrate 20 and then is continuously peeled off, the present invention is not limited to this and it may be cut by a cutter at a position between the respective substrates 20.

The respective substrates 20 are separated by this cutting. And the light-transmissible base film 14A and an unnecessary portion of the photosensitive resin layer 14B are peeled off by pulling a projecting portion from the substrate 20 after this cutting.

And although said half cutter 38 uses a pair of disk cutters 38A and 38B, the present invention is not limited to this and another cutter which runs a cutter having a straight blade in the direction of film width may be used and furthermore the position where a half cutter cuts a photosensitive resin layer may be at the downstream side of laminating rolls.

## Claims

1. A film applying method which exposes a laminated film formed by laminating at least a light-transmissible base film and a photosensitive resin layer on each other at least in a range where said photosensitive resin layer can be applied on a substrate, and then feeds the laminated film along a substrate conveying surface in a state where the photosensitive resin layer faces the film applying surface of substrates being conveyed on the substrate conveying surface, and sends the laminated film and the substrates into a laminating roll unit, and applies the laminated film on the substrates, and cuts said photosensitive resin layer by a cutter in the direction of film width before or after said applying operation at a position near an end portion in the conveying direction of the substrates; said film applying method making the edge of said cutter bite into said light-transmissible base film when cutting said photosensitive resin layer, and cutting it as leaving part of the thickness of said light-transmissible base film as it is not cut.

2. A film applying method as defined in claim 1, wherein the depth to which the edge of said cutter bites into said light-transmissible base film is 1/2 or less of the thickness of said transparent resin layer.

3. A film applying method as defined in claim 2, wherein the depth to which the edge of said cutter bites into said light-transmissible base film is 20µm or less.

4. A film applying method as defined in claim 2, wherein the depth to which the edge of said cutter bites into said light-transmissible base film is about 10µm.

5. A film applying method as defined in claim 1, wherein said laminated film is formed by laminating a cover film on the outside of said photosensitive resin layer, said photosensitive resin layer is cut at the upstream side of said laminating roll unit, and said cover film is cut at the same time as said cutting operation by said cutter in a state where it is laminated on the photosensitive resin layer, and after the cutting, said cover film is peeled off at least in a range where it is applied on the substrate from the photosensitive resin layer.

6. A film applying method as defined in claim 1, wherein a light-transmissible base film which is applied on said substrates and has a photosensitive resin layer cut on it is continuously peeled off from the substrates in a state where a portion of the photosensitive resin layer corresponding to each space between the respective substrates and being between the cutting lines made by said cutter is left as it is adhered to the light-transmissible base film.

7. A film applying method as defined in claim 6, wherein a pair of cutters are disposed leaving a space corresponding to the space between said substrates in the film feeding direction and these cutters cut the photosensitive resin layer and part of the thickness of the light-transmissible base film as moving in the direction of film width at the same time.

8. A film applying method as defined in claim 7, wherein said pair of cutters, respectively, are disk cutters capable of turning in the direction of film width.
